# FASCICULE DE BREVET EUROPEEN

(11) **EP 1 397 835 B1**
(45) Date de publication et mention de la délivrance du brevet: **05.04.2006**
(21) Numéro de dépôt: 02748966.5
(22) Date de dépôt: 20.06.2002
(51) Int. Cl.: H01L 23/373, C30B 33/06, G01B 15/00

(54) **PROCEDE DE CONTROLE DE L'ORIENTATION CRISTALLINE D'UNE STRUCTURE COMPOSITE**
VERFAHREN ZUM KONTROLLIEREN DER KRISTALLINEN ORIENTIERUNG EINER VERBUNDSTRUKTUR
METHOD OF CONTROLLING THE CRYSTAL ORIENTATION OF A COMPOSITE STRUCTURE

(30) Priorité: 22.06.2001 FR 0108257
(43) Date de publication de la demande: 17.03.2004
(73) Titulaire: COMMISSARIAT A L'ENERGIE ATOMIQUE, 75752 Paris Cédex 15 (FR)
(72) Inventeur: FOURNEL, Franck, F-38430 Moirans (FR); ASPAR, Bernard, F-38140 Rives (FR); MORICEAU, Hubert, F-38120 Saint-Egreve (FR)
(74) Mandataire: Simonnet, Christine
(86) Numéro de dépôt international: PCT/FR2002/002136
(87) Numéro de publication internationale: WO 2003/005443

(56) Documents cités:
- EP-A- 1 041 630
- WO-A-01/00522
- WO-A-01/42540
- FR-A- 2 781 082
- US-A- 5 902 687
- PATENT ABSTRACTS OF JAPAN vol. 010, no. 359 (E-460), 3 décembre 1986 (1986-12-03) & JP 61 158152 A (TOSHIBA CORP), 17 juillet 1986 (1986-07-17)
- FOURNEL F ET AL: "Nanometric patterning with ultrathin twist bonded silicon wafers" THIN SOLID FILMS, ELSEVIER-SEQUOIA S.A. LAUSANNE, CH, vol. 380, no. 1-2, 22 décembre 2000 (2000-12-22), pages 10-14, XP004226583 ISSN: 0040-6090

## Description

### Domaine technique

La présente invention concerne un procédé de contrôle de l'orientation cristalline d'une structure composite. Elle concerne également un procédé de fabrication d'une telle structure.

L'invention trouve des applications variées, par exemple, dans les domaines de la microélectronique, de l'optique intégrée et de la micromécanique et vise en particulier à fournir des substrats de grande taille présentant des propriétés adaptées à leur destination.

L'invention peut être mise à profit par exemple pour la réalisation de substrats composites du type Si/Si, Si/Ge, Ge/Ge, Si/SiC, SiC/SiC, SiC/Ge. Elle est aussi adaptée à toute autre association homogène ou hétérogène de semi-conducteurs III-IV, ou II-VI, de diamant, de carbure de silicium, de supraconducteurs, de matériaux magnétiques, de matériaux piézoélectriques ou encore, plus généralement, de matériaux se présentant sous forme poly-cristalline texturée ou mono-cristalline. Les matériaux cristallins peuvent être associés entre-eux ou à des matériaux amorphes, ou céramiques ou plastique.

### Etat de la technique antérieure.

Les substrats, utilisés notamment dans les domaines techniques mentionnés ci-dessus, sont de plus en plus fréquemment des substrats composites qui présentent un support et une partie superficielle dans laquelle sont réalisés les composants. On connaît un certain nombre de techniques de fabrication de tels substrats composites.

Celles-ci consistent pour l'essentiel à transférer des couches dites "structures secondaires", généralement minces, d'une structure primaire ou "donneuse" vers une structure de support ou "receveuse".

La séparation de la couche mince, ou structure secondaire, de la structure primaire, a lieu par découpage clivage ou fracture, technique bien connue, décrite dans le document (1) dont les références sont précisées à la fin de la description. Cette technique consiste, par exemple, à former dans la structure primaire une couche enterrée de fragilisation et de fracturer la structure primaire selon cette couche pour en détacher la structure secondaire.

Le découpage, le clivage ou la fracture, peuvent être assistés par l'exercice de contraintes mécaniques, ou thermiques. Des outils de traction, de cisaillement, des traitements d'attaque chimique ou de pelage, l'application d'un jet de fluide, l'utilisation d'un laser de découpe sont autant de moyens susceptibles d'être mis en oeuvre pour provoquer ou favoriser la séparation des structures secondaires de la structure primaire. Une illustration en est donnée dans les documents (2) et (3) dont les références sont également précisées à la fin de la description.

Les structures secondaires sont ensuite reportées sur les structures de support avec lesquelles elles sont solidarisées. Cette opération peut encore faire appel à différentes techniques de collage avec ou sans substance adhésive, par exemple par adhésion moléculaire.

Les techniques de transfert des structures secondaires, bien connues en soi, sont illustrées, en outre, par les documents (4) à (7) dont les références sont précisées à la fin de la présente description.

Un des paramètres importants pour le transfert de couches de matériau cristallin ou plus généralement de structures présentant au moins une partie cristalline, est l'alignement des réseaux cristallins.

Il peut s'agir d'un alignement entre les réseaux cristallins des structures secondaires reportées ou l'alignement du réseau cristallin des structures secondaires avec celui de la structure de support.

L'alignement est compris ici comme ne signifiant pas nécessairement la colinéarité des réseaux cristallins mais comme le contrôle de l'angle que font les réseaux entre eux.

On définit un angle dit de « twist » comme étant l'angle de la rotation qu'on effectue entre deux réseaux cristallins autour d'un axe perpendiculaire à la surface des échantillons considérés.

On définit un angle dit de « tilt » comme étant l'angle minimum de la rotation qu'on effectue autour d'un axe parallèle à la surface pour aligner le vecteur normal à cette surface, avec un des trois axes du réseau cristallin d'une couche cristalline de la structure. A partir des angles de tilt de surface, on définit un angle de "tilt d'interface" entre deux couches cristallines qui présentent chacune un angle de tilt de surface. Les valeurs des angles de "twist" et de "tilt d'interface" sont définis de telle façon que la combinaison de ces deux rotations permette d'aligner les deux réseaux cristallins. En d'autres termes, entre deux structures cristallines, il existe une rotation permettant de passer d'un réseau cristallin à l'autre et qui peut se décomposer en deux rotations respectivement parallèle et perpendiculaire aux deux surfaces existant entre les deux structures à assembler. Ces rotations correspondent aux angles de twist et de tilt d'interface. Les angles peuvent être définis entre deux structures cristallines posées l'une sur l'autre ou l'une à côté de l'autre.

On connaît par le document (8) des techniques permettant de révéler les axes cristallins d'une structure. Ces techniques impliquent une révélation chimique des axes et leur mise en oeuvre se heurte à des difficultés technologiques. De plus, ce document n'enseigne pas le contrôle du tilt d'interface ni la réalisation d'un pavage contrôlé en direction cristallographique. La nécessité d'une surface utile et d'une dépense de temps importantes sont les principaux obstacles à la révélation des axes cristallins. De plus, la précision de la connaissance de l'orientation des axes ne dépasse généralement pas 0,1°.

Enfin, il est possible de révéler les axes cristallins par des mesures aux rayons X. Celles-ci, outre le fait d'être consommatrices en temps, sont difficiles à mettre en oeuvre et voient leur utilisation limitée dans le cas des films minces.

### Exposé de l'invention.

L'invention a pour but de proposer un procédé de fabrication de structures composites comprenant le transfert d'au moins une structure secondaire issue d'une structure primaire vers une structure de support, et ne présentant pas les limitations évoquées ci-dessus.

Un autre but est de proposer un procédé de contrôle précis et simple de l'orientation des structures secondaires entre elles ou par rapport à la structure de support.

Pour atteindre ces buts, l'invention concerne un procédé selon la revendication 1 de contrôle de l'orientation de structures secondaires présentant au moins une partie cristalline, lors d'un transfert des structures secondaires depuis une structure dite primaire sur laquelle les structures secondaires présentent une orientation cristalline initiale identique à celle de la structure primaire ou présentant un désalignement connu par rapport à la structure primaire, vers au moins une structure-support. Le procédé comprend :
a) la formation sur chaque structure secondaire, lorsque les structures secondaires sont solidaires de la structure primaire, d'au moins un repère d'orientation, le repère présentant une orientation arbitraire par rapport à ladite orientation cristalline initiale, mais permettant une orientation relative de la structure secondaire, et
b) lors du report des structures secondaires sur au moins une structure de support, la disposition des structures secondaires de façon à orienter de façon contrôlée leurs repères d'orientation.

Dans le cas où les structures secondaires sont monocristallines, il est possible de prévoir des repères présentant une orientation identique pour chaque structure secondaire.

On entend par structure, un ensemble formé d'une ou de plusieurs couches, et susceptible de présenter au moins une partie en un matériau cristallin (monocristallin ou polycristallin). Dans son expression la plus simple, il peut s'agir d'une couche cristalline unique recouverte ou non d'une couche amorphe ou d'une couche amorphe recouverte d'une couche cristalline, par exemple. Il convient aussi de préciser que la structure de support ne présente pas nécessairement de partie cristalline. Des structures plus complexes, telles que des structures multicouches peuvent également être retenues.

Le transfert des structures secondaires peut avoir lieu sur une seule structure de support ou sur une pluralité de telles structures. En particulier, le transfert peut avoir lieu sur une pluralité de structures de support "filles" provenant d'une même structure de support dite structure de support "mère". Ceci est le cas, par exemple, lorsque les structures de support "filles" sont obtenues par découpage, clivage, ou fracture d'un monocristal faisant office de structure mère.

Ces structures de support "filles" font alors également office de structures de support. On peut former sur chaque structure de support "fille", lorsqu'elle est solidaire de la structure de support "mère" au moins un repère d'orientation permettant une orientation relative des structures de support "filles".

La formation des repères d'orientation peut avoir lieu avant le transfert, par exemple de telle sorte qu'après le transfert, ces repères sont pour partie dans la structure secondaire ("ou dans les structures filles") et dans la structure primaire (ou dans la structure "mère"). Les repères dans ces deux types de structures ont ainsi la même orientation par rapport à la structure cristalline.

Les repères peuvent être réalisés en une ou plusieurs étapes dans les structures secondaires (ou "filles") et primaires (ou "mère"). Des étapes de transfert et de fabrication de nouveaux repères peuvent être intercalées. On utilise avantageusement, pour réaliser les nouveaux repères, des repères définis pour la structure secondaire ("ou fille") précédente.

Un alignement angulaire précis est ainsi possible lors du transfert, sans qu'une étape de révélation des directions cristallines ne soit nécessaire. Un alignement aisé peut être effectué à partir des simples repères d'orientation. Cet alignement peut être réalisé entre les structures secondaires ou entre chaque structure secondaire et la structure de support ou entre chaque structure secondaire et des structures support "filles".

Les repères d'orientation sont de préférence des formes géométriques simples, telles que des lignes parallèles, des carrés ou toute autre forme susceptible d'effectuer un repérage angulaire. Dans une mise en oeuvre perfectionnée du procédé, les repères d'orientation peuvent être des échelles graduées. De telles échelles graduées sont en soi connues. Elles permettent un ajustage angulaire particulièrement précis. Les repères peuvent être aussi constitués par les bords des structures secondaires ("ou filles").

La réalisation des repères d'orientation peut avoir lieu, par exemple, par lithographie et gravure ou par perçage laser.

L'orientation contrôlée des repères d'orientation lors du transfert permet notamment de retrouver l'alignement des réseaux cristallins qui existait dans la structure primaire. Ceci ne nécessite par ailleurs pas la connaissance absolue des directions cristallines.

L'opération qui consiste, lors du transfert, à orienter les structures secondaires transférées les unes par rapport aux autres, comprend, par exemple, un alignement angulaire. Elle peut aussi consister à respecter un décalage angulaire donné par rapport au repère d'orientation de l'une des structures secondaires utilisée comme structure de test. Elle peut encore consister à respecter un décalage angulaire par rapport à au moins un autre repère, solidaire, par exemple, de la structure de support ou de structures support "filles".

Lorsque la structure de support est elle-même cristalline, ou tout au moins présente une partie cristalline, il peut être souhaitable d'orienter non seulement les structures secondaires les unes par rapport aux autres, mais aussi par rapport à l'orientation cristalline de la structure de support ou des structures de support "filles".

Dans ce cas, l'étape b peut comporter, après le transfert d'au moins une première structure secondaire depuis une structure primaire sur une structure de support, présentant au moins une partie cristalline, la détermination d'au moins un angle de décalage des orientations cristallines des parties cristallines de la première structure secondaire transférée et de la structure de support, puis, lors du transfert de structures secondaires subséquentes, l'ajustage, sur le support, de la disposition des repères en fonction du décalage déterminé.

La première structure secondaire transférée servant de test peut être orientée de façon arbitraire sur la structure du support.

La structure secondaire de test et une structure "fille" quelconque peuvent également être utilisées pour déterminer le décalage. On ajuste ensuite l'orientation des autres structures secondaires sur une ou des autres structures "filles".

Il convient de noter que dans ce procédé ni la connaissance de l'orientation cristalline de la structure de support ni celle des structures secondaires n'est nécessaire. On ne détermine qu'un décalage entre l'orientation des structures cristallines, et non une orientation absolue.

La détermination de l'angle de décalage peut avoir lieu, par exemple, selon une technique de mesure de dislocations d'interface entre la structure secondaire et la structure de support par exemple par microscopie électronique à transmission ou par une technique de mesure par rayons X d'un décalage entre les orientations des parties cristallines. On peut se reporter à ce sujet au document (9) dont les références sont précisées à la fin de la présente description.

D'autres techniques de mesure par révélation chimique, par voie optique ou acoustique, ou toute autre méthode sensible au décalage cristallin, peuvent également être retenues.

La compensation des décalages des orientations cristallines, déterminés entre la (les) première(s) structure(s) transférée(s) et la (les) structure(s) de support, peut avoir lieu, par exemple, en maintenant un décalage constant entre l'orientation des repères des structures secondaires subséquentes et celle du repère de la structure secondaire de test. Les angles de twist peuvent ainsi être annulés et les angles de tilt réduits ou également annulés. L'annulation ou la compensation des angles de twist ou de tilt s'entend entre les structures secondaires ou entre les structures secondaires et la structure support, ou entre les structures secondaires et les structures de support "filles".

L'invention concerne également un procédé de fabrication de structures composites comprenant des structures secondaires solidaires d'au moins une structure de support. Le procédé comprend :
- la délimitation de structures secondaires présentant au moins une partie cristalline dans une structure primaire et
- le transfert des structures secondaires sur une structure de support présentant au moins une partie cristalline, en contrôlant l'orientation relative des structures secondaires et de la structure de support conformément au procédé décrit précédemment.

La délimitation des structures secondaires dans la structure primaire permet leur transfert individuel. Selon une possibilité, les structure secondaires peuvent être délimitées dans la structure primaire par une couche enterrée. Il s'agit par exemple d'une couche formée par implantation d'hydrogène ou de gaz rares. Elle permet de délimiter à chaque fois une structure secondaire et la détacher de la structure primaire selon une technique de fracture décrite dans le document (1) cité précédemment.

La fixation des structures secondaires sur la structure de support peut avoir lieu par collage avec ou sans apport de matière (adhésif). Il s'agit, par exemple d'un collage moléculaire hydrophile, hydrophobe, eutectique ou anodique.

Lorsque des structures secondaires sont solidaires d'une structure de support, il est possible de former à la surface libre de ces structures composites une couche de matériau, par exemple, par épitaxie. La partie cristalline des structures secondaires est alors utilisée comme germe de croissance. Si les structures secondaires utilisées comme germes de croissance sont disposées de façon juxtaposées, une couche formée par épitaxie peut occuper une surface relativement importante. La couche formée par épitaxie peut recouvrir, par exemple, une structure composite en forme de disque de 200 mm de diamètre. Ceci peut être particulièrement avantageux pour des matériaux semi-conducteurs III-V ou II-VI tels que le GaAs ou l'InP ou SIC. Les diamètres des monocristaux disponibles pour ces matériaux ne sont à l'heure actuelle que de l'ordre de 100 mm et 50 mm respectivement.

Après l'épitaxie, la structure obtenue peut servir de structure primaire pour réitérer le procédé. Les structures secondaires peuvent ne pas couvrir l'ensemble de la surface de la structure support. Avantageusement, il peut exister une ou plusieurs désorientations entre la surface des structures secondaires et la surface du support. Lors de l'épitaxie réalisée sur l'ensemble des structures cela peut conduire à l'apparition de joints de grain à la jonction entre une partie de la matière déposée dont l'orientation est conforme à celle de la surface de la structure secondaire sur laquelle elle à commencer à croître et une partie de la matière déposée dont l'orientation est conforme à celle de la surface de la structure de support sur lequel elle a commencé à croître. Ceci peut être très intéressant pour créer des jonctions supraconductrices au niveau des joints de grain simplement en utilisant les structures secondaires.

L'invention peut ainsi être mise à profit pour la réalisation de substrats compliants ou de pseudo-substrats. On entend par pseudo-substrats et substrats compliants, respectivement des substrats dont le paramètre de maille est adapté à un matériau que l'on souhaite déposer par épitaxie, et des substrats pouvant accueillir l'épitaxie de matériaux de paramètre de maille indifférents. Dans ce cas, l'épitaxie peut être réalisée sans induire de défauts, par exemple des dislocations.

D'autres caractéristiques et avantages de l'invention ressortiront de la description qui va suivre, en référence aux figures des dessins annexés. Cette description est donnée à titre purement illustratif et non limitatif.

### Brève description des figures.

- Les figures 1 à 3 sont des vues de dessus de substrats montrant un transfert de couches minces avec contrôle de l'orientation cristalline de ces couches, conformément à l'invention.
- Les figures 4 à 6 sont des vues de dessus d'un premier et d'un deuxième substrats et illustrent l'assemblage de ces substrats conformément à l'invention.
- Les figures 7 à 9 sont des représentations schématiques de substrats et illustrent une technique d'assemblage d'une pluralité de substrats deux à deux, en respectant leur orientation cristalline, conformément à l'invention.
- La figure 10 montre le pavage d'un premier substrat avec une pluralité de seconds substrats prélevés sur un même monocristal, conformément à l'invention.

La figure 11 montre des substrats donneurs et receveurs et illustre une mise en oeuvre itérative du procédé de l'invention.

### Description détaillée de modes de mise en oeuvre de l'invention.

Dans la description qui suit, des parties identiques, similaires ou équivalentes des différentes figures portent les mêmes références. Par ailleurs, les différentes parties ne sont pas nécessairement représentées à une échelle uniforme pour des raisons de clarté des figures.

Dans un premier exemple de mise en oeuvre de l'invention, on utilise comme structure primaire un premier substrat A de germanium cristallin présentant un diamètre de 100 mm. Un deuxième substrat B, en silicium cristallin, avec un diamètre de 200 mm est utilisé comme structure de support.

Dans une première étape, on réalise un repère d'orientation Va sous la forme d'une paire d'échelles graduées, gravée, sur une face superficielle du premier substrat. Deux repères d'orientation Vb1, Vb2 du même type que le repère Vₐ du premier substrat sont également réalisés sur le deuxième substrat B. Les repères du deuxième substrat sont angulairement centrés et alignés sur un même diamètre. Ils sont réalisés en des endroits distincts, et aptes à permettre une superposition ultérieure avec des repères d'orientation du premier substrat (Va), lors du collage des structures secondaires. La réalisation des repères a lieu par photolithographie et gravure.

Une première structure secondaire, en l'occurrence un film mince A1 est détachée du premier substrat A selon une zone de fragilisation, non représentée, réalisée par implantation ionique. Le film mince A1 qui porte le repère d'orientation Va est reporté sur le deuxième substrat B, dans la région du premier repère d'orientation Vb1.

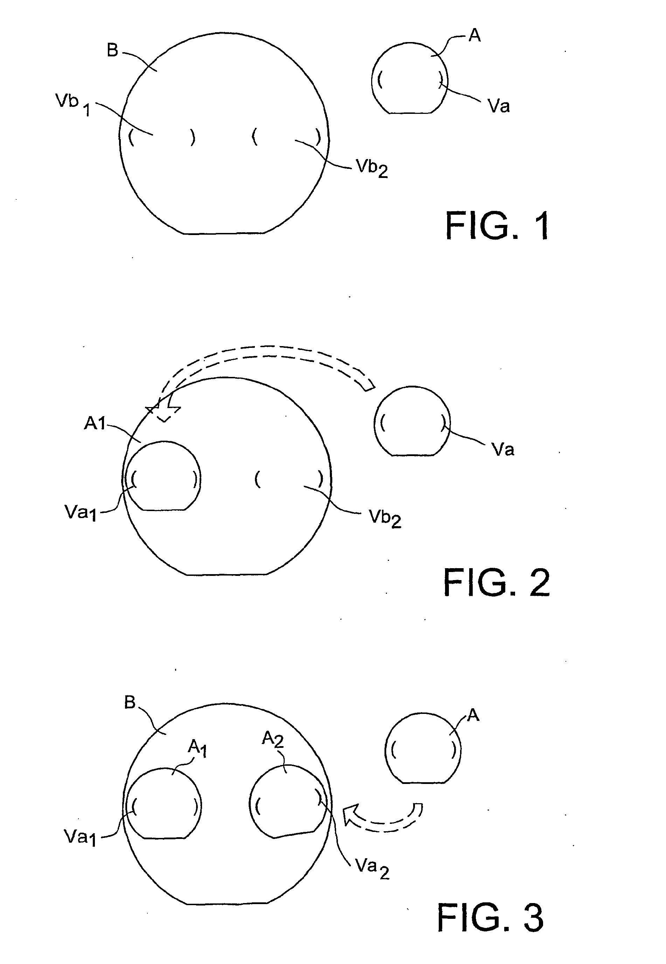

Le report, illustré par la figure 2 a lieu sans précaution d'orientation.

Un décalage entre l'orientation cristalline du deuxième substrat B et la couche mince A1 est ensuite mesuré. Cette opération peut avoir lieu en prélevant un morceau de test comprenant une partie des deux structures B et A1 en contact. De façon connue par microscopie TEM ou par rayons X, par exemple, on peut mesurer les dislocations d'interface et déduire la désorientation cristalline entre B et A.

Une deuxième couche mince A2, sur laquelle on a un repère d'orientation Va2, identique au repère Va1 de la première couche mince, est ensuite détachée du même premier substrat A, et reportée également sur le deuxième substrat B. Le report a lieu, comme le montre la figure 3, dans la région du deuxième repère d'orientation Vb2 de ce substrat, c'est-à-dire à côté de la première couche mince.

De façon avantageuse, on utilise les repères Va1 demeuré sur le support en le prolongeant pour former le repère Va2. Dans ce cas et bien que l'orientation cristalline du premier substrat A soit inconnue, on sait que le deuxième repère d'orientation Va2 présente par rapport à l'orientation cristalline de la deuxième couche mince A2, le même écart angulaire que le premier repère d'orientation Va1 par rapport à l'orientation cristalline de la première couche mince A1.

Grâce aux repères d'orientation et à la connaissance du décalage d'orientation entre les structures cristallines du substrat B et de la première couche mince A1 il est possible d'effectuer une rotation de la deuxième couche mince A2 jusqu'à obtenir un angle de twist souhaité. Le fait de prélever des structures secondaires par une telle méthode permet d'assurer des tilts de surface presque identiques pour les structures secondaires. De plus, comme l'angle de tilt d'interface de collage dépend de l'angle de twist on peut calculer l'angle de tilt en fonction de l'angle de twist.

En particulier, la deuxième couche mince A2 peut être orientée de façon à réduire, voire à annuler son décalage d'orientation avec le substrat de support B. Ceci a lieu en faisant tourner la deuxième couche mince A2 et/ou le support B selon un axe perpendiculaire au plan de collage.

L'utilisation de repères d'orientation sous la forme de paires d'échelles graduées permet de contrôler les alignements ou les angles de twist ou de tilt avec une précision de l'ordre du centième de degré. Des méthodes de microscopie optique permettent de faire cet alignement. La longueur d'onde est choisie pour traverser au moins une des structures secondaires ou de support, lorsqu'au moins une marque de repérage se situe à l'interface de collage.

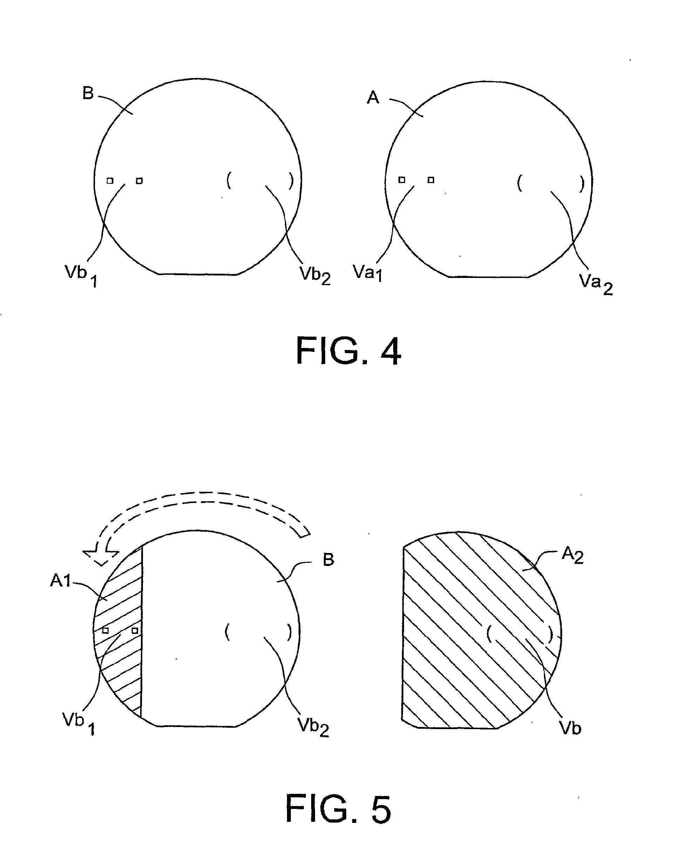

Un deuxième exemple de mise en oeuvre du procédé est illustré par les figures 4 à 6. Pour des raisons de simplification, les parties correspondantes à celles des figures précédentes sont repérées avec les mêmes références, même si leur forme diffère quelque peu.

Sur la figure 4, la structure primaire est une plaquette de silicium monocristallin A et la structure de support est une plaquette de silicium monocristallin B. Sur chacune de ces plaques, on pratique deux marques d'orientation indexées 1 et 2 en des endroits distincts, qui présentent mutuellement une position relative fixe et identique pour chaque plaquette. I1 s'agit respectivement de paires de carrés Va1, Vb1 et de paires d'échelles graduées Va2 et Vb2.

La première plaquette A est ensuite découpée en deux parties A1 et A2 portant respectivement les repères d'orientation Va1 et Va2. Comme le montre la figure 5, la partie A1 portant les repères d'orientation sous la forme de deux carrés est reportée et collée sur la plaquette B, en faisant coïncider les carrés avec ceux du premier repère d'orientation Vb1 de la deuxième plaquette B.

Après ce premier report, on détermine, comme dans le premier exemple, l'angle de twist et de tilt d'interface imposé par le collage de la première partie A1 sur la plaquette B.

Or comme les échelles graduées, c'est-à-dire les deuxièmes repères d'orientation Va2 et Vb2 étaient initialement en relation fixe avec les premiers, c'est-à-dire les carrés, on connaît la désorientation relative de ces échelles graduées : il s'agit, du décalage déterminé entre les directions cristallines de la première partie A1 et la plaquette B (twist) et de tilt d'interface.

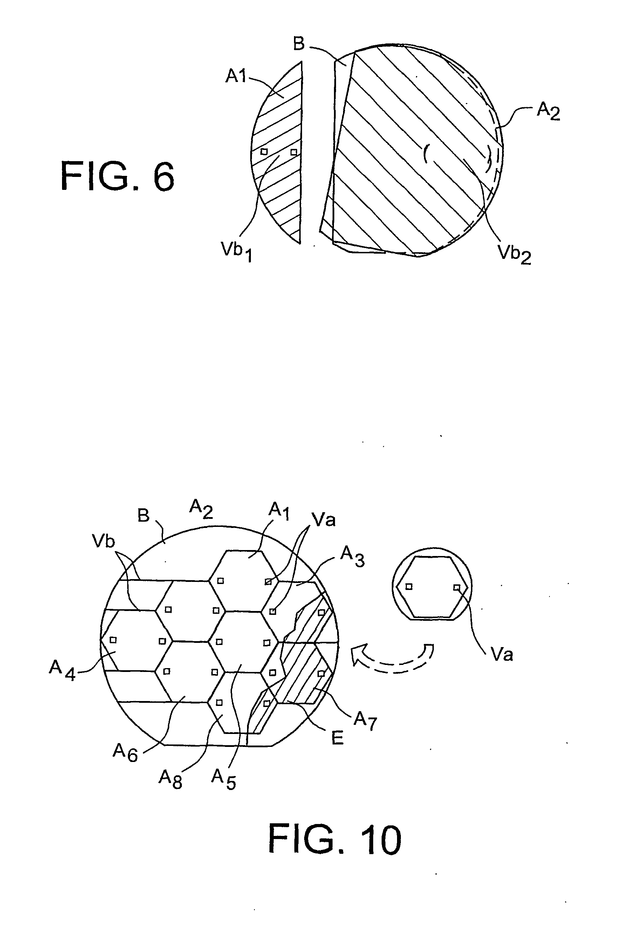

Il est ainsi possible lors du report de la deuxième partie A2, illustrée par la figure 6, de contrôler l'angle de twist et de tilt d'interface puisque ce dernier dépend de l'angle de twist, ou tout au moins l'ajuster à une valeur déterminée, en faisant tourner la deuxième partie A2 selon un axe perpendiculaire à son plan de collage. Pour faciliter la lecture des figures 5 et 6, les première et deuxième parties y sont hachurées.

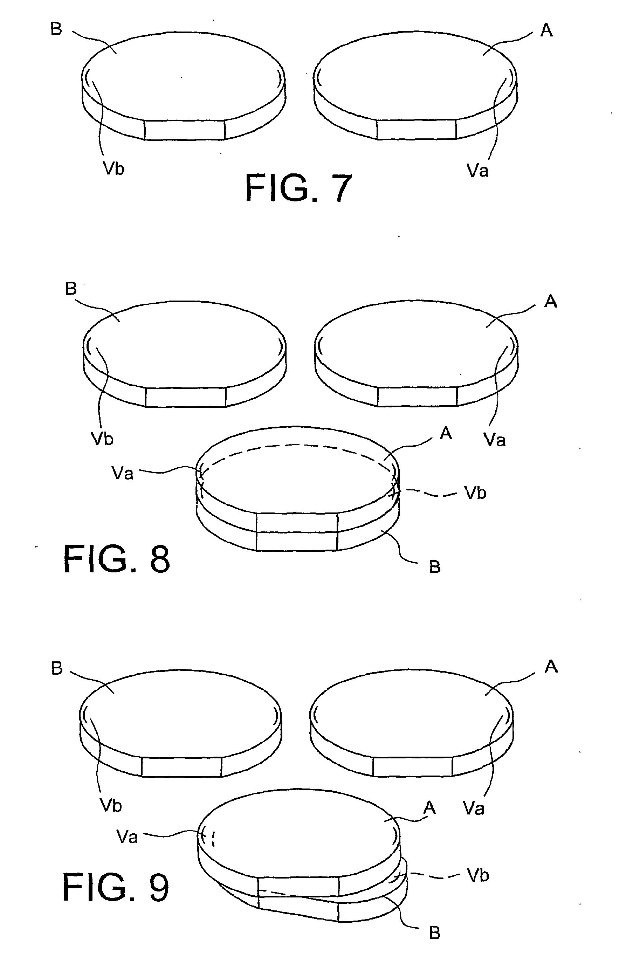

Un troisième exemple de mise en oeuvre du procédé est illustré par les figures 7 à 9. Dans cet exemple des structures secondaires A1, A2,... sont obtenues par séparation successive d'un premier substrat A utilisé comme structure primaire. Les structures secondaires sont reportées individuellement sur autant de structures de support B1, B2,... obtenues par séparation successif d'un deuxième substrat B. Les substrats A et B sont représentés à la figure 7.

Des verniers Va et Vb, servant de repères d'orientation, sont gravés dans les premier et deuxième substrats A et B avec une profondeur suffisante pour se retrouver de façon identique sur l'ensemble des structures A1,A2... ., B1,B2... obtenues ultérieurement par clivage.

Un premier assemblage de structures A1 et B1 en provenance des premier et deuxième substrats A et B est effectué, comme le montre la figure 8, en alignant angulairement les verniers Va et Vb.

Après l'assemblage des deux structures, un décalage de leurs orientations cristallines est mesuré comme dans les exemples précédents.

Puis, comme le montre la figure 9, les structures subséquentes A2, B2,... sont assemblées en ménageant un certain décalage angulaire dans l'alignement de leurs verniers Va et Vb. Celui-ci peut être sélectionné pour contrôler le décalage entre les orientations cristallines.

Lorsque d'autres structures subséquentes provenant des premier et deuxième substrats A et B sont assemblées par la suite, un décalage angulaire entre leurs verniers Va et Vb est aussi contrôlé, et il peut être identique à celui des structures A2 et B2 de la figure 9, ou différent.

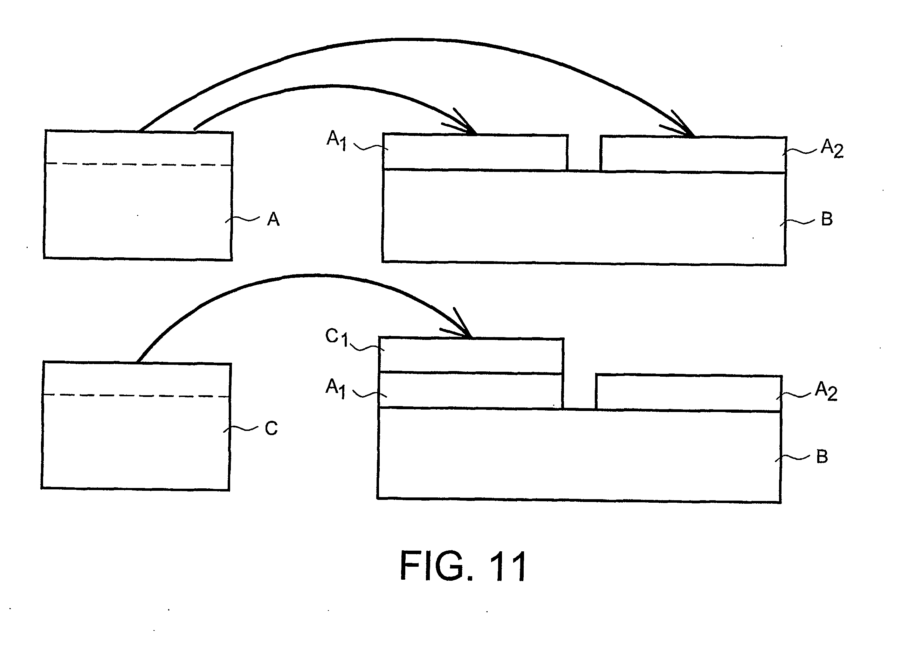

Un autre exemple, illustré par la figure 10, montre le report, conformément à l'invention d'une pluralité de structures secondaires cristallines A1, A2, ..A7, A8... sur une structure de support B. Les structures secondaires proviennent toutes d'une même structure primaire et portent toutes des repères d'orientation Va présentant la même orientation par rapport à leur réseau cristallin. Les repères d'orientation Va sont tous pareillement alignés sur des lignes parallèles de la structure de support B. Les lignes parallèles constituent également un repère d'orientation Vb de la structure de support. L'alignement cristallin mutuel des structures secondaires et leur angle de twist uniforme permet de les utiliser efficacement pour l'épitaxie d'une couche de recouvrement E partiellement représentée. Il convient de préciser que, dans cet exemple la structure de support B ne présente pas nécessairement de partie cristalline.

Les structures secondaires A1, A2, peuvent présenter toutes les mêmes dimensions Elles peuvent présenter de plus une forme permettant un recouvrement de la structure de support sans interstices. Il s'agit en l'occurrence de structures secondaires hexagonales.

Grâce au transfert qui conserve l'orientation cristalline des germes, et grâce à l'épitaxie subséquente, il est possible d'obtenir des substrats de diamètres importants avec des couches superficielles en des matériaux tels que le SiC ou de GaAs. A titre d'exemple on peut « paver » un substrat d'un diamètre de 200mm à partir d'un monocristal de SiC de 35mm de diamètre.

Des variantes de la mise en oeuvre du procédé de l'invention peuvent comporter une étape de retournement d'une ou de plusieurs structures secondaires. Ceci permet notamment de choisir la face qui est mise en contact avec la structure de support et la face qui subit éventuellement une épitaxie. Le procédé peut être itéré en utilisant la structure résultant de l'assemblage comme une nouvelle structure donneuse ou une nouvelle structure de support. Elle peut subir à cet effet des étapes intermédiaires telles qu'un dépôt de matière et/ou d'épitaxie, et/ou de polissage par exemple.

Si des structures primaires donneuses sont suffisamment épaisses on peut déterminer préalablement les orientations cristallines des unes par rapport aux autres, notamment par rayons X.

Il est possible ainsi de contrôler les orientations cristallines de structures secondaires lors de reports successifs.

La figure 11, montre à ce sujet un transfert successif vers une structure de support B de deux structures secondaires A1 et A2. Les deux structures secondaires A1 et A2 proviennent d'un même substrat primaire A.

Puis, de façon subséquente, une structure secondaire supplémentaire C1, provenant d'une autre structure primaire C, est transférée sur la première structure secondaire A1, utilisée désormais comme structure de support.

La connaissance des orientations cristallines relatives des structures primaires A et C permet, conformément à l'invention, de contrôler l'orientation relative des structures secondaires A1 et C1.

### Documents cités.

(1)
   US-A-5 374 564,
(2)
   K. Sakaguchi et al., 1999 IEEE International, SOI Conférence, oct. 1999, p.110
(3)
   F. Henley et al., European Semiconductor, Feb. 2000, p. 25
(4) FR-A-2 681 472
(5) FR-A-2 748 850
(6) FR-A-2 748 851
(7) FR-A-2 781 082
(8)
   "Angular alignement for wafer bonding" Chou et al. SPIE, Vol. 2879, 1996, pages 291-299
(9)
   "Grazing Incidence, XRay studies of twist-bonded Si/Si and Si/SiO₂ interface", D. Buttard, et al., PhysicaB, 283(1-3) (2000), P. 103.

## Revendications

1. Procédé de contrôle de l'orientation de structures secondaires (A1, A2) présentant au moins une partie cristalline, lors d'un transfert des structures secondaires depuis une structure dite primaire (A) sur laquelle les structures secondaires présentent une orientation cristalline initiale identique à la structure primaire ou présentant un désalignement connu par rapport à la structure primaire, vers au moins une structure de support (B), le procédé comprenant :
a) la formation, lorsque les structures secondaires sont solidaires de la structure primaire (A), d'au moins un repère d'orientation (Va, Va1, Va2), le repère présentant une orientation arbitraire par rapport à ladite orientation cristalline initiale, mais permettant une orientation relative de la structure secondaire, et
b) le report d'un ensemble de structures secondaires sur la structure de support (B), en orientant les structures secondaires transférées les unes par rapport aux autres de manière contrôlée grâce à leurs repères d'orientation.

2. Procédé selon la revendication 1, lors d'un transfert d'au moins une structure secondaire depuis une structure primaire (A) sur une structure de support (B) présentant au moins une partie cristalline, dans lequel l'étape b) comprend, après le transfert d'au moins une première structure secondaire (A1) sur la structure support (B) avec une disposition arbitraire du repère d'orientation de la structure secondaire, la détermination d'au moins un angle de décalage des orientations cristallines entre parties cristallines de la première structure secondaire (A1) et de la structure de support (B), puis lors du transfert de structures secondaires subséquentes (A2), l'ajustage de la disposition de leurs repères d'orientation en fonction de l'angle de décalage déterminé.

3. Procédé selon la revendication 2, dans lequel on détermine l'angle de décalage selon une technique de mesure de dislocations d'interface entre la structure secondaire (A1) et la structure de support (B) et/ou une technique de mesure par rayons X d'un décalage entre les orientations des parties cristallines.

4. Procédé selon la revendication 1 ou 2 dans lequel on forme également au moins un repère d'orientation (Vb, Vb1, Vb2) sur la structure de support, et dans lequel on oriente les repères d'orientation des structures secondaires par rapport au repère d'orientation de la structure de support.

5. Procédé selon la revendication 1 ou 3, dans lequel on forme les repères d'orientation selon des techniques de lithographie et de gravure.

6. Procédé selon l'une quelconque des revendications 1 à 3, dans lequel on forme des repères d'orientation sous la forme de lignes parallèles, de verniers ou de carrés.

7. Procédé de fabrication de structures composites comprenant des structures secondaires (A, A1, A2) solidaires d'au moins une structure de support (B), comprenant :
- la délimitation de structures secondaires (A1, A2) présentant au moins une partie cristalline, dans une structure primaire (A), et
- le transfert des structures secondaires sur une structure de support (B) présentant au moins une partie cristalline, en contrôlant l'orientation relative des structures secondaires et de la structure de support conformément au procédé de l'une quelconque des revendications 1 à 6.

8. Procédé selon la revendication 7, comprenant en outre, après le transfert, l'épitaxie d'une couche (E) recouvrant l'ensemble des structures secondaires solidaires d'une même structure de support, l'épitaxie utilisant la partie cristalline de chaque structure secondaire comme germe de croissance.

9. Procédé selon la revendication 8, dans lequel on forme par épitaxie une couche s'étendant au moins en partie sur une structure secondaire et au moins en partie sur une structure de support, de façon à former au moins un joint de grain.

10. Procédé selon la revendication 7, dans lequel la délimitation des structures secondaires a lieu par découpage ou par formation dans la structure primaire d'une couche de séparation.

11. Procédé selon 1a revendication 7, dans lequel l'étape de transfert comprend la séparation d'au moins une structure secondaire (A1, A2) de la structure primaire (A) et le collage de la structure secondaire sur la structure de support (B).

## Patentansprüche

1. Verfahren zum Kontrollieren der Orientierung wenigstens einen kristallinen Teil aufweisender Sekundärstrukturen (A1, A2) bei einem Transfer der Sekundärstrukturen von einer sogenannten Primärstruktur (A), auf der die Sekundärstrukturen eine kristalline Anfangsorientierung aufweisen, identisch mit der Primärstruktur oder mit einer im Verhältnis zu der Primärstruktur bekannten Abweichung, zu wenigstens einer Trägerstruktur (B), wobei dieses Verfahren umfasst:
a) das Bilden - wenn die Sekundärstrukturen mit der Primärstruktur (A) verbunden sind - wenigstens einer Orientierungsmarkierung (Va, Va1, Va2), die in Bezug auf die genannte ursprüngliche kristalline Orientierung eine arbiträre Orientierung aufweist, aber eine relative Orientierung der Sekundärstruktur ermöglicht, und
b) das Übertragen einer Gruppe von Sekundärstrukturen auf die Trägerstruktur (B), indem man die transferierten Sekundärstrukturen dank ihrer Orientierungsmarkierung kontrolliert im Verhältnis zueinander ausrichtet.

2. Verfahren nach Anspruch 1, bei einem Transfer wenigstens einer Sekundärstruktur von einer Primärstruktur (A) auf eine wenigstens einen kristallinen Teil aufweisende Trägerstruktur (B), in dem der Schritt b) nach dem Transfer wenigstens einer ersten Sekundärstruktur (A1) auf die Trägerstruktur (B) mit einer arbiträren Anordnung der Orientierungsmarkierung der Sekundärstruktur die Bestimmung wenigstens eines Verschiebungswinkels der kristallinen Orientierungen zwischen kristallinen Teilen der ersten Sekundärstruktur (A1) und der Trägerstruktur (B) und dann beim Transfer der nachfolgenden Sekundärstruktur (A2) die Justierung der Anordnung ihrer Orientierungsmarkierungen in Abhängigkeit von dem bestimmten Verschiebungswinkel umfasst.

3. Verfahren nach Anspruch 2, in dem man den Verschiebungswinkel gemäß einer Technik zum Messen der Grenzflächenverschiebung zwischen der Sekundärstruktur (A1) und der Trägerstruktur (B) und/oder einer Technik zum Messen einer Verschiebung zwischen den Orientierungen der kristallinen Teile mittels Röntgenstrahlen bestimmt.

4. Verfahren nach Anspruch 1 oder 2, in dem man auch auf der Trägerstruktur eine Orientierungsmarkierung (Vb, Vb1, Vb2) bildet, und in dem man die Orientierungsmarkierungen der Sekundärstrukturen in Bezug auf die Orientierungsmarkierung der Trägerstruktur orientiert.

5. Verfahren nach Anspruch 1 oder 3, in dem man die Orientierungsmarkierungen mittels Lithographie- und Ätztechniken bildet.

6. Verfahren nach einem der Ansprüche 1 bis 3, bei dem man Orientierungsmarkierungen in Form von parallelen Linien, von Nonien oder von Quadraten bildet.

7. Verfahren zur Herstellung von mit wenigstens einer Trägerstruktur (B) verbundene Sekundärstrukturen (A, A1, A2) umfassenden Verbundstrukturen, umfassend:
- die Abgrenzung von wenigstens einen kristallinen Teil aufweisenden Sekundärstrukturen (A1, A2) in einer Primärstruktur (A), und
- den Transfer der Sekundärstrukturen auf eine Trägerstruktur (B) mit wenigstens einem kristallinen Teil, indem man die relative Orientierung der Sekundärstrukturen und der Trägerstruktur entsprechend dem Verfahren nach einem der Ansprüche 1 bis 6 kontrolliert.

8. Verfahren nach Anspruch 7, das außerdem nach dem Transfer die Epitaxie einer alle mit einer selben Trägerstruktur verbundenen Sekundärstrukturen bedeckende Schicht (E) umfasst, wobei die Epitaxie den kristallinen Teil jeder Sekundärstruktur als Wachstumskeim benutzt.

9. Verfahren nach Anspruch 8, bei dem man durch Epitaxie eine Schicht ausbildet, die sich wenigstens teilweise über eine Sekundärstruktur und wenigstens teilweise über eine Trägerstruktur erstreckt, um wenigstens eine Korngrenze zu bilden.

10. Verfahren nach Anspruch 7, in dem die Abgrenzung der Sekundärstrukturen durch Schneiden oder durch das Ausbilden einer Trennschicht in der Primärstruktur stattfindet.

11. Verfahren nach Anspruch 7, in dem der Transferschritt das Abtrennen wenigstens einer Sekundärstruktur (A1, A2) von der Primärstruktur (A) und das Kleben der Sekundärstruktur auf die Trägerstruktur (B) umfasst.

## Claims

1. Process for controlling the orientation of secondary structures (A1, A2) with at least one crystalline part, during the transfer of secondary structures from a primary structure (A) on which the secondary structures have an initial crystalline orientation identical to the orientation of the primary structure or with a known misalignment with respect to the primary structure, onto at least one support structure (B), the process comprising:
a) the formation of at least one orientation mark (Va, Va1, Va2) when the secondary structures are fixed to the primary structure (A), the mark having an arbitrary orientation with respect to the said initial crystalline orientation, but allowing relative orientation of the secondary structure, and
b) the transfer of a set of secondary structures onto the support structure (B), orienting the transferred secondary structures with respect to one another in controlled manner by means of their orientation marks.

2. Process according to claim 1, during a transfer of at least one secondary structure from a primary structure (A) onto a support structure (B) with at least one crystalline part, in which step b) includes the determination of at least one offset angle of the crystalline orientations between the crystalline parts of the first secondary structure (A1) and the support structure (B) after the transfer of at least one first secondary structure (A1) onto the support structure (B) with an arbitrary arrangement of the orientation mark of the secondary structure, and then when the subsequent secondary structures (A2) are transferred, adjustment of the arrangement of the orientation marks as a function of the determined offset angle.

3. Process according to claim 2, in which the offset angle is determined using a technique of measuring interface dislocations between the secondary structure (A1) and the support structure (B) and / or a technique for using X-rays to measure an offset between the orientations of the crystalline parts.

4. Process according to either claim 1 or 2, in which at least one orientation mark (Vb, Vb1, Vb2) is also formed on the support structure, and in which the orientation marks of the secondary structures are oriented with respect to the orientation marks of the support structure.

5. Process according to claim 1 or 3, in which the orientation marks are formed using lithography and etching techniques.

6. Process according to claims 1 to 3, in which orientation marks are formed in the form of parallel lines, verniers or squares.

7. Process for manufacturing composite structures comprising secondary structures (A, A1, A2) fixed to at least one support structure (B), comprising:
- delimitation of secondary structures (A1, A2) with at least one crystalline part in a primary structure (A), and
- transfer of secondary structures onto a support structure (B) with at least one crystalline part, controlling the relative orientation of secondary structures and the support structure in accordance with any one of claims 1 to 6 process.

8. Process according to claim 7, also comprising epitaxy of a layer (E) covering all secondary structures bonded to the same support structure after the transfer, the epitaxy using the crystalline part of each secondary structure as a growth germ.

9. Process according to claim 8, in which epitaxy is used to form a layer extending at least partly onto a secondary structure and at least partly onto a support structure, in order to form at least one grain boundary.

10. Process according to claim 7, in which the delimitation of secondary structures takes place by cutting or by formation of a separation layer in the primary structure.

11. Process according to claim 7, in which the transfer step comprises the separation of at least one secondary structure (A1, A2) from the primary structure (A) and bonding of the secondary structure onto the support structure (B).
